# EUROPEAN PATENT SPECIFICATION

(11) **EP 2 156 477 B1**
(45) Date of publication and mention of the grant of the patent: **22.06.2011**
(21) Application number: 08767391.9
(22) Date of filing: 22.04.2008
(51) Int. Cl.: H01L 31/18, H01L 31/0232, H01L 31/0236

(54) **Method of making a FRONT ELECTRODE INCLUDING PYROLYTIC TRANSPARENT CONDUCTIVE COATING ON TEXTURED GLASS SUBSTRATE FOR USE IN PHOTOVOLTAIC DEVICE**
Herstellungsverfahren für eine FRONTELEKTRODE MIT EINER PYROLYTISCHEN, TRANSPARENTEN UND LEITFÄHIGEN BESCHICHTUNG AUF EINEM TEXTURIERTEN GLASSUBSTRAT ZUR VERWENDUNG IN EINER PHOTOVOLTAISCHEN VORRICHTUNG
Procédé de fabrication d'une ÉLECTRODE AVANT COMPRENANT UN REVÊTEMENT CONDUCTEUR TRANSPARENT PYROLYTIQUE SUR UN SUBSTRAT VITREUX TEXTURÉ À UTILISER DANS UN DISPOSITIF PHOTOVOLTAÏQUE

(30) Priority: 14.06.2007 US 812078
(43) Date of publication of application: 24.02.2010
(60) Divisional application: 11162390.6
(73) Proprietor: Guardian Industries Corp., Auburn Hills, MI 48326-1714 (US)
(72) Inventor: KRASNOV, Alexey, Canton, MI 48187 (US); THOMSEN, Scott, V., South Lyon, MI 48178 (US)
(74) Representative: Hess, Peter K. G.
(86) International application number: PCT/US2008/005152
(87) International publication number: WO 2008/153623

(56) References cited:
- US-A- 3 411 934
- US-A- 5 091 764
- US-A- 5 256 858
- US-A1- 2005 016 583

## Description

Certain example embodiments of this invention relate to a method of making a photovoltaic device including an electrode such as a front electrode/contact provided on a textured front glass substrate. In curtain example embodiments, what is to be the front glass substrate of a photovoltaic device is textured via roller(s) to form a textured surface. Thereafter, a front electrode is formed on the textured surface of the glass substrate via pyrolysis. The front electrode may be of or include a transparent conductive oxide (TCO) such as tin oxide and/or fluorinated tin oxide in certain example embodiments. In certain example instances, this is advantageous in that efficiency of the photovoltaic device can be improved by increasing light absorption by the active semiconductor via both increasing light intensity passing through the front glass substrate and front electrode, and increasing the light path in the semiconductor photovoltaic conversion layer.

### BACKGROUND AND SUMMARY OF EXAMPLE EMBODIMENTS OF INVENTION

Photovoltaic devices are known in the art (e.g., see U.S. Patent Nos. 6,784,361, 6,288,325, 6,613,603, and 6,123,824, the disclosures of which are hereby incorporated herein by reference). Amorphous silicon (a-Si) photovoltaic devices, for example, include a front electrode or contact. Typically; the transparent front electrode is made of a pyrolytic transparent conductive oxide (TCO) such as zinc oxide or tin oxide formed on a substrate such as a glass substrate. Thin film amorphous silicon solar cells are gaining in popularity due to savings in semiconductor material and thus cost; less than 1 µm of Si thickness compared to about 250 µm or so of Si thickness in conventional single crystal Si solar cells. The small thickness of the semiconductor absorber in a-Si solar cells, however, allows a substantial amount of solar light to pass through the absorber without producing electron-hole pairs, thereby lowering the efficiency of the photovoltaic device. There are several ways to increase efficiency of an a-Si solar cell, including roughening of the front electrode. Moreover, higher solar light transmission and higher conductivity of the front electrode may result in higher device efficiency.

Document US 2005/0016583 A1 describes a method for making a glass substrate with an electrode, wherein a standard soda lime silica glass is textured by for example chemical etching or sand blasting before a conductive layer is applied by pyrolysis from precursors.

US document 3,411,934 discloses a typical glass composition for a soda-lime silica glass.

In many instances, the transparent front electrode is formed of a single layer using a method of chemical pyrolysis where precursors are sprayed onto the glass substrate at approximately 400 to 600 degrees C. Typical pyrolitic fluorine-doped tin oxide TCOs as front electrodes may be about 400-800 nm thick, which provides for a sheet resistance (Rₛ) of about 7-15 ohms/square. It is known to increase the light path in thin film photovoltaic devices by etching/patterning a surface of a sputtered TCO front electrode after it has been deposited on the front glass substrate. It is also known to deposit some types of TCO on a flat glass substrate in a high process pressure environment in order to cause texturing of the TCO front electrode via column structure growth in the TCO. Unfortunately, both of these techniques often compromise the electrical properties of the TCO front electrode of the photovoltaic device and/or result in an increased thickness of the pre-etched TCO.

Moreover, it is possible to sputter-deposit a zinc aluminum oxide TCO own a glass substrate, and to then etch the surface of the zinc aluminum oxide TCO to be used as the front electrode. However, to achieve a textured sputtered zinc aluminum oxide front electrode, a thicker TCO is needed because the etching of the TCO removes a significant part of the thickness of the material. This removal of a significant part of the TCO thickness is wasteful and results in higher overall costs of the coating.

In view of the above, it will be appreciated that there exists a need in the art for an improved method of making a front electrode structure for use in a photovoltaic device or the like.

Certain example embodiments of this invention relate to a method of making a photovoltaic device including an electrode such as a front electrode/contact provided on a textured front glass substrate. The glass is a low-iron soda-lime-silica based glass in certain example embodiments. According to the invention what is to be the front glass substrate of a photovoltaic device is textured via roller(s) to form a textured surface. Thereafter, a front electrode is formed on the textured surface of the glass substrate via pyrolysis. The pyrolytic front electrode may be of or include a transparent conductive oxide (TCO) such as tin oxide and/or fluorinated tin oxide in certain example embodiments. In alternative example embodiments, the front electrode may be of or include pyrolytic zinc oxide which may or may not be doped with one or more of boron, gallium or other n-type dopant. In certain example instances, this is advantageous in that efficiency of the photovoltaic device can be improved by increasing light absorption by the active semiconductor via both increasing light intensity passing through the front glass substrate and front electrode, and increasing the light path in the semiconductor photovoltaic conversion layer.

In certain example embodiments, the glass substrate is textured by providing one or a pair of rollers in the float facility and using the patterning roller(s) to texture at least one major surface of the glass substrate in or just after the tin bath but before the pyrolytic TCO front electrode is formed on the glass. After the roller(s) texture the glass, the pyrolytic front electrode is formed on the textured surface of the glass substrate, and it may be used in a photovoltaic device or the like.

Moreover, it has also surprisingly been found that in order to achieve good haze properties due to etching, the ratio MgO/CaO in the glass is at least about 0.45, more preferably at least about 0.47. These values have unexpectedly been found to provide for much better haze values compared to if these values are not met.

In certain example embodiments of this invention, the average roughness at the textured surface of the front glass substrate is from about 0.010 to 1000 µm, more preferably from about 1 to 500 µm, and most preferably from about 1 to 200 µm, or from about 1 to 100 µm.

In certain example embodiments, the pyrolytic front electrode may be formed via spray pyrolysis of the like. In certain example embodiments, the electrode is deposited in a conformal manner so that both major surfaces of the electrode are shaped in a manner similar to that of the textured surface of the glass substrate on which the electrode has been deposited. Thus, the surface of the front electrode closest to the semiconductor absorber film of the photovoltaic device is also textured. In certain example embodiments, there is no need to etch the surface of the front electrode after it has been deposited.

Certain example embodiments of this invention are advantageous in that efficiency of the photovoltaic device can be improved by (a) increasing the solar light trapping within the semiconductor absorber due to the textured surface(s) of both the front electrode and front glass substrate, and (b) increasing the light path in the semiconductor absorber (or photovoltaic conversion layer) due to light scattering at larger angles, while at the same time maintaining good electrical properties of the front electrode.

In certain example embodiments of this invention, there is provided a method of making a photovoltaic device, the method comprising: providing a soda-lime-silica based glass substrate which comprises from about 67-75% SiO₂ from about 10-20% Na₂O from about 5-15% CaO, from about 0.1 to 8% MgO, and from about 0.1 to 5% Al₂O₃; texturing at least one major surface of the glass substrate to form a textured surface of the glass substrate; after said texturing, pyrolytically forming a transparent conductive oxide based coating comprising tin oxide on the textured surface of the glass substrate; and using the pyrolytically formed transparent conductive oxide based coating, formed on the textured surface of the glass substrate, as a front electrode in a photovoltaic device.

### BRIEF DESCRIPTION OF THE DRAWINGS

FIGURE 1 is a cross sectional view of an example photovoltaic device made according to an example embodiment of this invention.

FIGURE 2 is a flowchart illustrating certain steps performed in making a photovoltaic device according to an example embodiment of this invention.

### DETAILED DESCRIPTION OF EXAMPLE EMBODIMENTS OF THE INVENTION

Referring now more particularly to the figures in which like reference numerals refer to like parts/layers in the several views.

Photovoltaic devices such as solar cells convert solar radiation into usable electrical energy. The energy conversion occurs typically as the result of the photovoltaic effect. Solar radiation (e.g., sunlight) impinging on a photovoltaic device and absorbed by an active region of semiconductor material (e.g., a semiconductor film including one or more semiconductor layers such as a-Si layers, the semiconductor sometimes being called an absorbing layer or film) generates electron-hole pairs in the active region. The electrons and holes may be separated by an electric field of a junction in the photovoltaic device. The separation of the electrons and holes by the junction results in the generation of an electric current and voltage. In certain example embodiments, the electrons flow toward the region of the semiconductor material having n-type conductivity, and holes flow toward the region of the semiconductor having p-type conductivity. Current can flow through an external circuit connecting the n-type region to the p-type region as light continues to generate electron-hole pairs in the photovoltaic device.

In certain example embodiments, single junction amorphous silicon (a-Si) photovoltaic devices have a semiconductor film which includes three semiconductor layers. In particular, a p-layer, an n-layer and an i-layer which is intrinsic. The amorphous silicon film (which may include one or more layers such as p, n and i type layers) may be of hydrogenated amorphous silicon in certain instances, but may also be of or include hydrogenated amorphous silicon carbon or hydrogenated amorphous silicon germanium, or the like, in certain example embodiments of this invention. For example and without limitation, when a photon of light is absorbed in the i-layer it gives rise to a unit of electrical current (an electron-hole pair). The p and n-layers, which contain charged dopant ions, set up an electric field across the i-layer which draws the electric charge out of the i-layer and sends it to an optional external circuit where it can provide power for electrical components. It is noted that while certain example embodiments of this invention are directed toward thin film amorphous-silicon based photovoltaic devices (e.g., single-junction or micromorph types), this invention is not so limited and may be used in conjunction with other types of photovoltaic devices in certain instances including but not limited to devices including other types of semiconductor material, single or tandem thin-film solar cells, CdS and/or CdTe photovoltaic devices, polysilicon and/or microcrystalline Si photovoltaic devices, and the like.

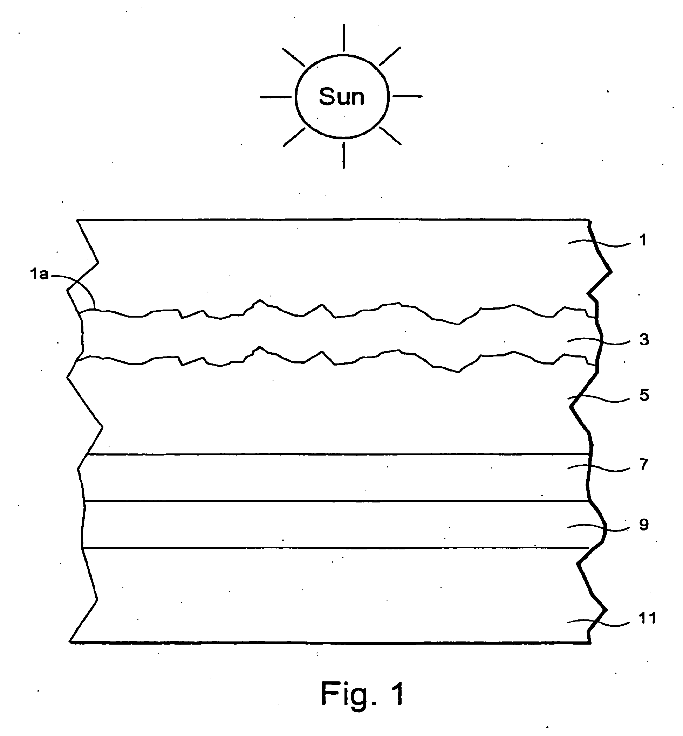

Fig. 1 is a cross sectional view of a photovoltaic device. The photovoltaic device includes transparent front glass substrate 1 having a textured surface la closest to the semiconductor film, front electrode 3 (which may be multi-layered or single-layered), active and absorbing semiconductor film 5 of or including one or more semiconductor layers (such as pin, pn, pinpin tandem layer stacks, or the like), optional back electrode/contact 7 which may be of a TCO and/or metal(s), an optional polymer based encapsulant or adhesive . 9 of a material such as ethyl vinyl acetate (EVA) or the like, and an optional rear substrate 11 of a material such as glass. The front glass substrate 1 is on the light incident side of the photovoltaic device. Of course, other layer(s) which are not shown may also be provided in the device. Front glass substrate 1 and/or rear substrate 11 may be made of soda-lime-silica based glass in certain example embodiments of this invention; and may have low iron content and/or an antireflection coating thereon to optimize transmission in certain example instances. Glass 1 and/or 11 may or may not be thermally tempered in certain example embodiments of this invention. Additionally, it will be appreciated that the word "on" as used herein covers both a layer being directly on and indirectly on something, with other layers possibly being located therebetween. Optionally, an antireflective film (not shown) or other film may be provided on the light-incident side of the front substrate 1 in certain example instances.

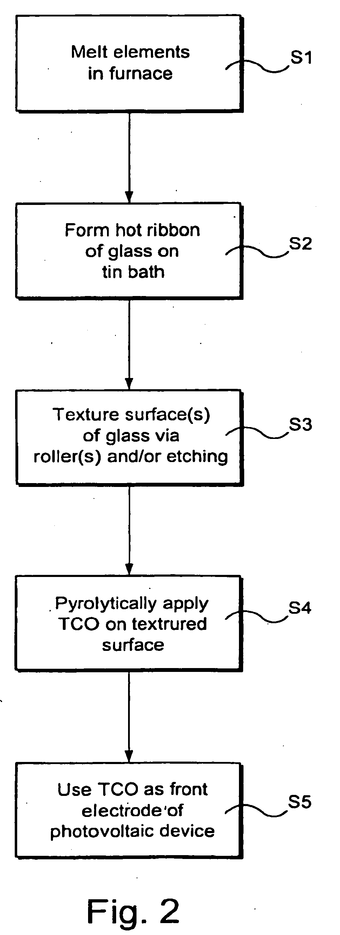

_{.} Fig. 2 is a flowchart illustrating a process of making a photovoltaic device according to an example embodiment of this invention. First, the elements (e.g., soda, lime, silica, and optional colorants such as iron and/or the like) are melted in the furnace at the glass-making facility (S1 in Fig. 2). As is known in the art, in the float process of making glass, the molten material leaves the furnace and glass is formed in the form of a hot ribbon on a tin bath in the tin bath portion of the float process (S2 in Fig. 2). At or soon after the tin bath, one or both major surface(s) of the glass (to be substrate 1) is/are textured (S3 in Fig. 2). As explained herein, this texturing of the glass is carried out via roller(s). In certain example embodiments, the texturing (e.g., via roller(s)) may be performed when the glass ribbon is at a temperature of from about 570 to 750 degrees C. After the glass has been textured, a pyrolytic coating (e.g., TCO of or including tin oxide and/or fluorinated tin oxide) is deposited (e.g,. via spray pyrolysis) on the textured surface 1 a of the glass 1 (S4 in Fig. 2). In certain example embodiments, the coating 3 may be applied via spray pyrolysis when the glass ribbon is at a temperature of from about 400-600 degrees C, more preferably from about 400-570 degrees C. After the glass has cooled and optionally been cut, the glass substrate 1 with the coating 3 thereon is used in a photovoltaic device so that the TCO coating 3 is used as a front electrode of the device (S5 in Fig. 2).

In certain example embodiments, the glass substrate 1 is textured by providing one or a pair of rollers in the float facility (in step S3). The patterning roller(s) may be used to texture at least one major surface of the glass substrate 1 in or just after the tin bath but before the pyrolytic TCO front electrode 3 is formed on the glass. In certain example embodiments, the texturing via at least one roller causes a prismatic pattern comprising a feature density of at least five characters per cm² to be formed as the textured surface la, more preferably of at least ten or fifteen characters per cm². After the roller(s) texture the glass 1, the pyrolytic front electrode 3 is formed on the textured surface 1 a of the glass substrate, and it may be used in a photovoltaic device or the like.

As a non-inventive reference example, the glass substrate 1 may be textured by etching (e.g., via hydrofluoric acid or the like, via immersion and/or spraying with the acid inclusive solution). The etching of one or both major surfaces of the glass substrate 1 may be performed after the glass has been made, or alternatively in a float line just after the tin bath but before the pyrolytic TCO front electrode 3 is formed on the glass. In certain reference examples the etching may comprise immersing the soda-lime-silica based glass 1 in an acid inclusive solution such as hydrofluoric acid (e.g., HF in aqueous solution) and/or hydrofluoric acid with a buffer, such as BaSO₄ of the like, in order to selectively dissolve some of the glass thereby producing at least one textured/patterned substantially transparent surface la a of the glass substrate 1. It has surprisingly been found that in order to achieve good haze properties, the etching ratio of the glass composition, namely (Al₂O₃/Na₂O) x (MgO/CaO) in the glass, is desired to be at least about 0.010, more preferably at least about 0.030, and most preferably at least about 0.035. Moreover, it has also surprisingly been found that in order to achieve good haze properties due to etching, the ratio MgO/CaO in the glass is at least about 0.45, more preferably at least about 0.47. These values have unexpectedly been found to provide for much better haze values compared to if these values are not met. After the glass is textured via such etching, the front electrode 3 is formed on the textured surface 1 a of the glass substrate, and it may be used in a photovoltaic device or the like.

In certain example embodiments, following texturing of the glass 1, the pyrolytic front electrode 3 may be formed via spray pyrolysis of the like. In certain example embodiments, the electrode 3 is deposited in a conformal manner so that both major surfaces of the electrode 3 are shaped in a manner similar to that of the textured surface 1a of the glass substrate 1 on which the electrode has been deposited. Thus, the surface of the front electrode 3 closest to the semiconductor absorber film 5 of the photovoltaic device is also textured. In certain example embodiments, there is no need to etch the surface of the front electrode 3 after it has been deposited. In certain example embodiments of this invention, the average roughness at the textured surface la of the front glass substrate 1 and/or electrode 3 is from about 0.010 to 1000 _{f}.1m, more preferably from about 1 to 500 µm, and most preferably from about 1 to 200 µm, even more preferably from about 1 to 100 µm.

Certain example embodiments of this invention are advantageous in that efficiency of the photovoltaic device can be improved by (a) increasing the solar light trapping within the semiconductor absorber due to the textured surface(s) of both the front electrode and front glass substrate, and (b) increasing the light path in the semiconductor absorber (or photovoltaic conversion layer) due to light scattering at larger angles, while at the same time maintaining good electrical properties of the front electrode.

The front electrode 3 may be a single-layer of pyrolytic tin oxide (which may or may not be fluorinated in certain example instances) in certain example embodiments. Other materials may instead be used.. In certain example embodiments, such a front electrode 3 may be from about 100 to 1,500 nm thick, more preferably from about 100 to 1,100 nm thick, and most preferably from about 200-800 nm thick. The electrode 3 (e.g., of tin oxide) may contain a fluorine concentration of from about 1-20% in certain example embodiments, more preferably from about 3-15%. Electrode 3 may be deposited in a conformal manner so that both major surfaces of the electrode may be shaped in a manner similar to that of the interior etched/textured surface 1 a of the glass substrate 1 on which the electrode 3 has been deposited. In certain example embodiments, there is no need to etch the surface of the front electrode 3 after it has been deposited. In alternative example embodiments, the front electrode 3 may be made up of multiple layers.

In certain example embodiments of this invention, the average roughness on the etched/textured surface 1a of the front glass substrate 1 and/or the surface of the electrode 3 closest to the semiconductor 5 is from about 0.010 to 1000 µm, more preferably from about 1 to 500 µm, and most preferably from about 1 to 200 µm or from about 1 to 100 µm (measured as distance between a peak and adjacent valley on the textured surface). The textured surface 1 a of the glass substrate 1 may have a prismatic surface, a matte finish surface, or the like in different example embodiments of this invention. In certain example embodiments, the average peak-to-peak distance between adjacent peaks on the textured surface 1 a of the glass 1 (and/or on the surface of the electrode 3 closest to the semiconductor) is from about 0.010 to 5,000 µm, more preferably from about 10 to 2,000 µm. Because the front electrode is deposited (e.g., sputter-deposited) on the textured surface 1a of the front substrate, one or possibly both major surfaces of the front electrode 3 may also be textured in a similar manner.

Front glass substrate 1 utilizes soda-lime-silica based glass in certain example embodiments. In addition to base composition/glass, a colorant portion may be provided in order to achieve a glass that is fairly clear in color and/or has a high visible transmission. An exemplary soda-lime-silica base glass according to certain embodiments of this invention, on a weight percentage basis, includes the following basic ingredients:

**TABLE 1: EXAMPLE BASE GLASS**

| Ingredient | Wt. % |
|---|---|
| SiO₂ | 67-75% |
| Na₂O | 10-20% |
| CaO | 5-15% |
| MgO | 0.1-8% |
| Al₂O₃ | 0.1-5% |
| K₂O | 0-5% |

In addition to the base glass (e.g., see Table 1 above), in making glass according to certain example embodiments of the instant invention the glass batch includes materials (including colorants and/or oxidizers) which cause the resulting glass to be fairly neutral in color (slightly yellow in certain example embodiments, indicated by a slightly positive b* value) and/or have a high visible light transmission. These materials may either be present in the raw materials (e.g., small amounts of iron), or may be added to the base glass materials in the batch (e.g., cerium oxide).

Moreover, in addition to the ingredients in Table 1 above, other minor ingredients, including various conventional refining aids, such as SO₃ and the like may also be included in the base glass. In certain embodiments, for example, glass herein may be made from batch raw materials silica sand, soda ash, dolomite, limestone, with the use.of sulfate salts such as salt cake (Na₂SO₄) and/or Epsom salt (MgSO₄ x 7H₂O) and/or gypsum (e.g., about a 1:1 combination of any) as refining agents. In certain example embodiments, soda-lime-silica based glasses herein include by weight from about 10-15% Na₂O and from about 6-12% CaO. Moreover, from about 0.15 to 7% MgO, more preferably from about 1 to 7% MgO, is provided in the glass in certain example embodiments.

In certain example embodiments of this invention, the.glass of substrate 1 is soda-lime-silica based (see base glass above) and is based on low iron raw materials such that the glass has a total iron (Fe₂O₃) content, in terms ofwt.%, of no more than about 0.05%. In certain example embodiments, the glass has a total iron (Fe₂O₃) content of from about 0.010 to 0.045%, more preferably from about 0.010 to 0.035%, and most preferably from about 0.010 to 0.029%. This low iron content may result from the use of low-iron raw materials in making the glass, or alternatively may be added in certain example instances. Moreover, in certain example embodiments of this invention, the glass is extremely oxidized so as to have no or very little ferrous (Fe²⁺; FeO). In certain example embodiments of this invention, the glass has a %FeO of no more than about 0.0038%, more preferably no more than about 0.0030%, even more preferably no more than about 0.0015%, more preferably no more than about 0.0010%. This low %FeO, in combination with other features, permits the glass to have a higher %UV transmission, and thus a higher %TS transmission, in combination with neutral color and high visible transmission, which are beneficial in solar cell applications. However, more iron than that listed above may be used in the glass 1 in alternative embodiments of this invention.

In certain example non-limiting embodiments, there is no or very little cerium oxide in the glass. Cerium oxide is a UV absorber, and thus prevents UV from being transmitted through the glass. Thus, cerium oxide is not desired in certain solar cell embodiments of this invention. Accordingly, in certain example embodiments of this invention, the glass has no more than about 0.01 % cerium oxide, more preferably no more than about 0.001 % cerium oxide, still more preferably no more than about 0.0005% cerium oxide, and most preferably 0% cerium oxide. However, in alternative embodiments of this invention, it is possible to use a small amount of cerium oxide. For example and without limitation, in certain example embodiments of this invention, the glass contains; from about 0 to 0.2% cerium oxide, more preferably from about 0 to 0.1% cerium oxide, and possibly from about 0.001 to 0.09% cerium oxide. As with all material percentages herein, these amounts are in terms of wt.%. The term cerium oxide as used herein includes Ce₂O₃, CeO₂, or the like. In certain example instances, glasses including cerium oxide herein may be used in applications such as greenhouse glazings where UV protection is desired.

In certain example embodiments of this invention, the colorant portion is substantially free of other colorants (other than potentially trace amounts). However, it should be appreciated that amounts of other materials (e.g., refining aids, melting aids, colorants and/or impurities) may be present in the glass in certain other embodiments of this invention without taking away from the purpose(s) and/or goal(s) of the instant invention. For instance, in certain example embodiments of this invention, the glass composition is substantially free of, or free of, one, two, three, four or all of: erbium oxide, nickel oxide, cobalt oxide, neodymium oxide, chromium oxide, and selenium. The phrase "substantially free" means no more than 2 ppm, more preferably no more than 1 ppm, and possibly as low as 0 ppm of the element or material. It is noted that small amounts of titanium oxide may be included in certain instances.

Glass 1 according to certain example embodiments of this invention achieves a neutral or substantially clear color, high visible transmission, high IR transmission, high UV transmission, and high total solar (TS) transmission. In certain embodiments, resulting glasses according to certain example embodiments of this invention may be characterized by one or more of the following transmissive optical, composition, or color characteristics (for the optics, an example non-limiting reference thickness of about 4 mm is used). Note that Lta is visible transmission %. It is noted that in the table below the L*; a* and b* color values are determined per III. D65, 10 degree Obs.

**TABLE 2: CHARACTERISTICS OF EXAMPLE EMBODIMENTS**

| CharacteristicGeneral | More Preferred | Most Preferred | |
|---|---|---|---|
| Lta (Lt D65): | >= 85% | >= 91 % | >= 91.5% |
| %TS (ISO 9050): | >= 90% | >= 91% | >= 91.5% |
| %IR | >= 80% | >= 85% | >= 90% (or >= 91 %) |
| %UV (300-400 nm): | >= 80% | >= 84% | >= 85% (or 86%) |
| total iron (Fe₂O₃): | <=0.05% | 0.010-0.045% | 0.010-0.035% |
| % FeO (wt. %): | <= 0.0038% | <= 0.0030% | <= 0.0015% (or 0.0010%) |
| Glass Redox: | <= 0.12 | <= 0.09 | <= 0.08 or 0.06 |
| Batch Redox: | +12 to +30 | +15 to +30 | +20 to +30 |
| SO₃ | >= 0.25 | 0.29-0.50 | >= 0.30 (or >= 0.31) |
| L* (III. D65, 10 deg.): | 90-99 | 94-99 | 95-98 |
| a* (III. D65, 10 deg.): | -1.0 to +1.0 | -0.5 to +0.5 | -0.25 to 0.0 |
| b* (III. D65, 10 deg.): | 0 to +1.5 | +0.1 to +0.8 | +0.2 to +0.6 |

The aforesaid characteristics of the glass substrate 1 are for the glass substrate alone, not the overall photovoltaic device.

As can be seen from Table 2 above, glasses for substrate 1 of certain embodiments of this invention achieve desired features of fairly clear color and/or high visible transmission, with slightly positive b* color in certain embodiments, while not requiring iron to be eliminated from the glass composition. Moreover, high %UV and high %TS values are also achieved, which is advantageous for solar cell applications in that more radiation is permitted through the glass substrate I so that it can be converted to current or voltage. This may be achieved through the provision of the unique material combinations described herein, and/or process features discussed herein. For purposes of example and without limitation, glasses described in any of commonly owned U.S. Serial Nos. 11/049,292, 11/122,218 and/or 11/373,490 may be used for substrate 1 in different example embodiments of this invention. While these represent example glass that may be used for the substrate, it is of course possible to use other glass compositions for the substrate 1 in alternative embodiments of this invention.

As mentioned above, in order to achieve good haze properties, the soda-lime-silica based glass 1 preferably has an etching ratio [(Al₂O₃[Na₂)O) x (MgO/CaO)] of at least about 0.010, more preferably at least about 0.030, and most preferably at least about 0.035; and/or a ratio MgO/CaO of at least about 0.45 (more preferably at least about 0.47). These values have unexpectedly been found to provide for much better haze values of the front electrode 3 which is deposited on the textured surface 1a, compared to if these values in the glass are not met.

Referring to S5 in Fig. 2 and Fig. 1 in general, after the electrode 3 has been formed on substrate 1, the semiconductor film 5 (and optionally the optional back contact 7) may be formed on the substrate 1 and front electrode 3 via any suitable technique (e.g., CVD or the like), and then the rear substrate 11 may be laminated to the front electrode 1 via adhesive film 9 to form the photovoltaic device as shown in Fig. 1 (e.g., see step S3 in Fig. 5). The back contact 7 may or may not be conformal to/with the electrode 3, because the semiconductor 5 may or may not be planarizing in different example embodiments of this invention.

The active semiconductor region or film 5 may include one or more layers, and may be of any suitable material. For example, the active semiconductor film 5 of one type of single junction amorphous silicon (a-Si) photovoltaic device includes three semiconductor layers, namely a p-layer, an n-layer and an i-layer. The p-type a-Si layer of the semiconductor film 5 may be the uppermost portion of the semiconductor film 5 in certain example embodiments of this invention; and the i-layer is typically located between the p and n-type layers. These amorphous silicon based layers of film 5 may be of hydrogenated amorphous silicon in certain instances, but may also be of or include hydrogenated amorphous silicon carbon or hydrogenated amorphous silicon germanium, hydrogenated microcrystalline silicon, or other suitable material(s) in certain example embodiments of this invention. It is possible for the active region 5 to be of a double-junction or triple-junction type in alternative embodiments of this invention. CdTe and/or CdS may also be used for semiconductor film 5 in alternative embodiments of this invention.

Optional back contact or electrode 7 may be of any suitable electrically conductive material. For example and without limitation, the back contact or electrode 7 may be of a TCO and/or a metal in certain instances. Example TCO materials for use as back contact or electrode 7 include indium zinc oxide, indium-tin-oxide (ITO), tin oxide, and/or zinc oxide which may be doped with aluminum (which may or may not be doped with silver). The TCO of the back contact 7 may be of the single layer type or a multi-layer type in different instances. Moreover, the back contact 7 may include both a TCO portion and a metal portion in certain instances. For example, in an example multi-layer embodiment, the TCO portion of the back contact 7 may include a layer of a material such as indium zinc oxide (which may or may not be doped with aluminum or the like), indium-tin-oxide (ITO); tin oxide, and/or zinc oxide closest to the active region 5, and the back contact may include another conductive and possibly reflective layer of a material such as silver, molybdenum, platinum, steel, iron, niobium, titanium, chromium, bismuth, antimony, or aluminum further from the active region 5 and closer to the substrate 11. The metal portion may be closer to substrate 11 compared to the TCO portion of the back contact 7.

The photovoltaic module may be encapsulated or partially covered with an encapsulating material such as encapsulant 9 in certain example embodiments. An example encapsulant or adhesive for layer 9 is EVA or PVB. However, other materials such as Tedlar type plastic, Nuvasil type plastic, Tefzel type plastic or the like may instead be used for layer 9 in different instances.

In certain example embodiments of this invention, it is possible for the glass substrate 1 to have both a patterned side (e.g., patterned via rollers or the like, to form a prismatic side for instance) and a matte finish side. The matter finish side may be formed via acid etching techniques so that the matte finish side of the glass substrate is an acid etched side of the glass. The electrode 3 may be formed on the matte or acid-etched side of the glass substrate 1 which textured to some extent. Moreover, in certain example embodiments of this invention, the glass substrate 1 has a haze value of from about 8-20%, more preferably from about 12-18%.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the scope of the appended claims.

## Claims

1. A method of making a photovoltaic device, the method comprising:
providing a soda-lime-silica based glass substrate;
texturing at least one major surface of the glass substrate to form a textured surface of the glass substrate;
after said texturing, pyrolytically forming a transparent conductive oxide based coating comprising tin oxide on the textured surface of the glass substrate; and
using the pyrolytically formed transparent conductive oxide based coating, formed on the textured surface of the glass substrate, as a front electrode in a photovoltaic device, **characterized in that** the soda-lime silica based glass substrate comprises about 67-75% SiO₂, from about 10-20% Na₂O, from about 5-15% CaO, from about 0.1 to 8% MgO, and from about 0.1 to 5% Al₂O₃; and **in that** said texturing comprises using at least one roller at or soon after a tin bath using in making of the glass substrate to texture the at least one major surface of the glass substrate.

2. The method of claim 1, wherein the texturing comprises using at least one roller at a temperature of from about 570 to 750 degrees C to form the textured surface of the glass substrate.

3. The method of claim 2, wherein said texturing using at least one roller causes a prismatic pattern comprising a feature density of at least five characters per cm² to be formed as the textured surface, preferably of at least ten characters per cm² to be formed as the textured surface and most preferably of at least fifteen characters per cm² to be formed as the textured surface.

4. The method of claim 1, wherein a ratio MgO/CaO in the glass substrate is at least about 0.45, more preferably at least about 0.47.

5. The method of claim 1, wherein the front electrode comprises fluorinated tin oxide.

6. The method of claim 1, wherein the front electrode is from about 100 to 1,500 nm thick, and comprises tin oxide and/or zinc oxide.

7. The method of claim 1, wherein an average surface roughness at the textured surface of the front glass substrate and/or a textured surface of the front electrode closest to a semiconductor of the photovoltaic device is from about 1 to 500 µm.

## Patentansprüche

1. Ein Verfahren zur Herstellung einer photovoltaischen Vorrichtung, welches Verfahren die folgenden Schritte umfasst:
Bereitstellen eines auf Kalknatron basierenden Glassubstrats;
Strukturieren von zumindest einer Hauptoberfläche des Glassubstrats, um eine strukturierte Oberfläche des Glassubstrats zu erhalten;
nach dieser Strukturierung, pyrolytisches Bilden einer transparenten leitenden oxidbasierten Beschichtung umfassend Zinnoxid auf der strukturierten Oberfläche des Glassubstrats; und
Verwenden der pyrolytisch gebildeten transparenten leitfähigen oxidbasierten Beschichtung, die auf der strukturierten Oberfläche des Glassubstrats gebildet ist, als eine Frontelektrode in einer photovoltaischen Vorrichtung, **dadurch gekennzeichnet, dass** das Glassubstrat basierend auf Kalknatron umfasst etwa 67 bis 75 % SiO₂, von etwa 10 bis 20 % Na₂O, von etwa 5 bis 15 % CaO, von etwa 0,1 bis 8 % MgO, und von etwa 0,1 bis 5 % Al₂O₃; und **dadurch**, dass die Strukturierung die Verwendung von zumindest einer Walze bei oder kurz nach einem Zinnbad umfasst, welches bei der Herstellung des Glassubstrats verwendet wird, um die zumindest eine Hauptoberfläche des Glassubstrats zu strukturieren.

2. Das Verfahren nach Anspruch 1, wobei das Strukturieren die Verwendung von zumindest einer Walze bei einer Temperatur von etwa 570 bis 750°C umfasst, um die strukturierte Oberfläche des Glassubstrats zu bilden.

3. Das Verfahren nach Anspruch 2, wobei die Strukturierung unter Verwendung von zumindest einer Walze dazu führt, dass ein prismatisches Muster umfassend eine Merkmalsdichte von zumindest fünf Elementen pro cm² als die strukturierte Oberfläche gebildet wird, vorzugsweise von zumindest 10 Elementen pro cm² als die strukturierte Oberfläche gebildet wird und am meisten bevorzugt von zumindest 15 Elementen pro cm² als die strukturierte Oberfläche gebildet wird.

4. Das Verfahren nach Anspruch 1, wobei ein Verhältnis MgO/CaO in dem Glassubstrat zumindest etwa 0,45 beträgt, bevorzugt zumindest etwa 0,47 beträgt.

5. Das Verfahren nach Anspruch 1, wobei die Frontelektrode fluoriniertes Zinnoxid umfasst.

6. Das Verfahren nach Anspruch 1, wobei die Frontelektrode etwa 100 bis 1500 nm dick ist und Zinnoxid und/oder Zinkoxid umfasst.

7. Das Verfahren nach Anspruch 1, wobei eine durchschnittliche Oberflächenrauheit an der strukturierten Oberfläche des vorderen Glassubstrats und/oder eine strukturierte Oberfläche der Frontelektrode, die am nächsten zu einem Halbleiter der photovoltaischen Vorrichtung ist, von etwa 1 bis 500 µm beträgt.

## Revendications

1. Un procédé de fabrication d'un composant photovoltaïque, le procédé comprenant :
l'obtention d'un substrat en verre à base de silice sodocalcique ;
la texturation d'au moins une surface majeure du substrat en verre pour former une surface texturée du substrat en verre ;
après cette texturation, la formation pyrolytique d'un revêtement à base d'oxyde conducteur transparent comprenant de l'oxyde d'étain sur la surface texturée du substrat en verre ; et
l'utilisation du revêtement à base d'oxyde conducteur transparent formé pyrolytiquement, formé sur la surface texturée du substrat en verre, en tant qu'électrode frontale dans un composant photovoltaïque, **caractérisé en ce que** le substrat en verre à base de silice sodocalcique comprend environ 67 à 75 % de SiO₂, environ 10 à 20 % de Na₂O, environ 5 à 15 % de CaO, environ 0,1 à 8 % de MgO et environ 0,1 à 5 % de Al₂O₃ ; et **en ce que** ladite texturation comprend l'utilisation d'au moins un rouleau lors de l'utilisation d'un bain d'étain ou peu après celui-ci lors de la fabrication du substrat de verre pour texturer la au moins une surface majeure du substrat de verre.

2. Le procédé de la revendication 1, dans lequel la texturation comprend l'utilisation d'au moins un rouleau à une température comprise entre environ 570 et 750°C pour former la surface texturée sur le substrat de verre.

3. Le procédé de la revendication 2, dans lequel ladite texturation utilisant au moins un rouleau produit un motif prismatique comprenant une densité de caractéristiques d'au moins cinq caractères par cm² à former en tant que surface texturée, de préférence au moins dix caractères par cm² à former en tant que surface texturée et très préférablement au moins quinze caractères par cm² à former en tant que surface texturée.

4. Le procédé de la revendication 1, dans lequel un ratio MgO/CaO du substrat de verre est d'au moins environ 0,45, très préférablement d'au moins environ 0,47.

5. Le procédé de la revendication 1, dans lequel l'électrode frontale comprend de l'oxyde d'étain fluoré.

6. Le procédé de la revendication 1, dans lequel l'électrode frontale présente une épaisseur d'environ 100 à 1500 nm, et est formée d'oxyde de zinc et/ou d'oxyde d'étain.

7. Le procédé de la revendication 1, dans lequel une rugosité de surface moyenne à l'endroit de la surface texturée du substrat de verre frontal et/ou d'une surface texturée de l'électrode frontale la plus proche d'un semi-conducteur du composant photovoltaïque est d'environ 1 à 500 µm.
